# EUROPEAN PATENT APPLICATION

(11) **EP 4 654 244 A1**
(43) Date of publication of application: **26.11.2025**
(21) Application number: 24177490.0
(22) Date of filing: 22.05.2024
(51) Int. Cl.: H01J 37/22, H01J 37/26

(54) **SCANNING ELECTRON MICROSPCOPE FOR CAPTURING DIFFRACTION PATTERNS**

(71) Applicant: FEI COMPANY, Hillsboro, OR 97124 (US)
(72) Inventor: van Erve, Koen, Hillsboro, 97124-5793 (US); Stoks, Sander, Hillsboro, 97124-5793 (US)
(74) Representative: Korenberg, Alexander Tal

(57) **Abstract**

An electron microscope is disclosed and comprises an electron beam source for producing an electron beam, a vacuum chamber and a sample holder disposed in the vacuum chamber to hold a sample intersecting the electron beam. An image detector is disposed in the vacuum chamber to capture a diffraction pattern formed by electrons received from a sample held in the sample holder and produce image data comprising the captured diffraction pattern. A computing device is disposed in the vacuum chamber, connected to the image detector and configured to process the image data to produce compacted data from the image data. The compacted data requires less storage or bandwidth than the image data. A data connection connects the computing device to a data transmission, storage or further computing device outside the vacuum chamber to make the compacted data available outside the vacuum chamber. A method of operating the electron microscope is also disclosed.

## Description

### TECHNICAL FIELD

This disclosure relates to a scientific instrument and specifically a scanning electron microscope that captures diffraction patterns, such as Electron Backscattering Diffraction (EBSD) or N-dimensional Scanning Transmission Electron Microscope (ND STEM) patterns, and a method of operating the instrument.

### BACKGROUND

Electron microscopes operating in an EBSD or NDSTEM mode, or in any other mode that involves acquiring diffraction data at scan locations on a sample in accordance with a scanning pattern, such as a line or raster scan, acquire large amounts of data in the form of a diffraction pattern per location. Each diffraction pattern is captured by recording an image of diffracted electrons with an image detector having a plurality of pixels, for example converting electrons to photons with a scintillator material and having a detector, such as a charge coupled device or photo-multiplier, for each pixel. Other known arrangements for capturing the diffraction pattern include direct electron detectors. The image detector may for example have 256x256 pixels but can have substantially more pixels depending on the desired resolution of the diffraction pattern captured for each scan location. The detector is located together with a sample stage that holds the sample inside a vacuum chamber and may be separate from or integrated with the sample stage. As the sample is scanned, such electron microscopes generate a large amount of data that needs to be transferred from the detector inside the vacuum chamber to a processor outside the vacuum chamber that analyses the image data to generate diffraction data that characterises the captured diffraction pattern for each scan location.

### SUMMARY

Aspects of an invention are set out in the independent claims. Optional features of embodiments are set out in the dependent claims.

The inventors have realised that the large data volumes created by obtaining an image of a diffraction pattern at each scan location represents a challenge in terms of the data rate that is achievable with existing data connections that have relatively low bandwidth, such as unshielded flex-PCB with pogo pin connections, due to being configured to seemingly integrate with a feedthrough port in a vessel wall of the vacuum chamber.

To address this and other problems, in overview, an electron microscope is disclosed and comprises an electron beam source for producing an electron beam, a vacuum chamber and a sample holder disposed in the vacuum chamber to hold a sample intersecting the electron beam. An image detector is disposed in the vacuum chamber to capture a diffraction pattern formed by electrons received from a sample held in the sample holder and produce image data comprising the captured diffraction pattern. A computing device, for example comprising a Central Processing Unit (CPU) is disposed in the vacuum chamber, connected to the image detector and configured to process the image data to produce compacted data from the image data. The compacted data requires less storage or bandwidth than the image data. A data connection connects the computing device to a data transmission, storage or further computing device outside the vacuum chamber to make the compacted data available outside the vacuum chamber. A method of operating the electron microscope to capture, compact and transmit data is also disclosed.

Advantageously, by providing a computing unit inside the sample chamber, a high bandwidth data connection that does not need to cross a wall of the sample chamber can be used to transfer the image data from the image detector to the computing device, and a lower bandwidth connection can be used to transfer the compacted data produced by the computing device out of the sample chamber, which facilitates passing the data connection through the wall of the sample chamber.

The compacted data may be a compressed image of the diffraction pattern or may characterise the captured diffraction pattern. For example, the compacted data may characterise the captured diffraction pattern in momentum space or in Hough space. The compacted data may characterise a crystal lattice spacing, configuration and/or orientation at a location on the sample from which the electrons are received.

The electron microscope may be configured to capture diffraction patterns formed by backscattered electrons. For example, the diffraction pattern may be an EBSD pattern and the compacted data may comprise Kikuchi lines.

Alternatively or additionally, the electron microscope may be configured to capture diffraction patterns formed by transmitted electrons. For example, the diffraction pattern may be an ND STEM diffraction pattern and the diffraction data may comprise diffraction orders and/or intensities of diffraction peaks in the diffraction pattern.

The electron microscope may be configured to scan the electron beam across a plurality of locations on a sample held in the sample holder and the computing device is configured to process the image data and produce an instance of the compacted data for each of the plurality of locations.

For the avoidance of doubt, reference to the compacted data characterising a diffraction pattern in a certain space will be understood to refer the data comprising numeric data in that space that describes the pattern. Likewise, compacted data comprising Kikuchi lines, diffraction order and/or intensities of peaks in the diffraction pattern will be understood to mean that the compacted data comprises numeric data that describe these aspects of features of the diffraction pattern. In general, the compacted data may comprise numeric data describing or defining features or aspects of the diffraction patterns.

### BRIEF DESCRIPTION OF THE DRAWINGS

Disclosed implementations will now be described by way of example to illustrate aspects of the disclosure and with reference to the accompanying drawings, in which:
Figure 1 illustrates an electron microscope with a data capturing and processing arrangement;
Figure 2 illustrates a method of operating the electron microscope; and
Figure 3 illustrates a computing device.

### SPECIFIC DESCRIPTION

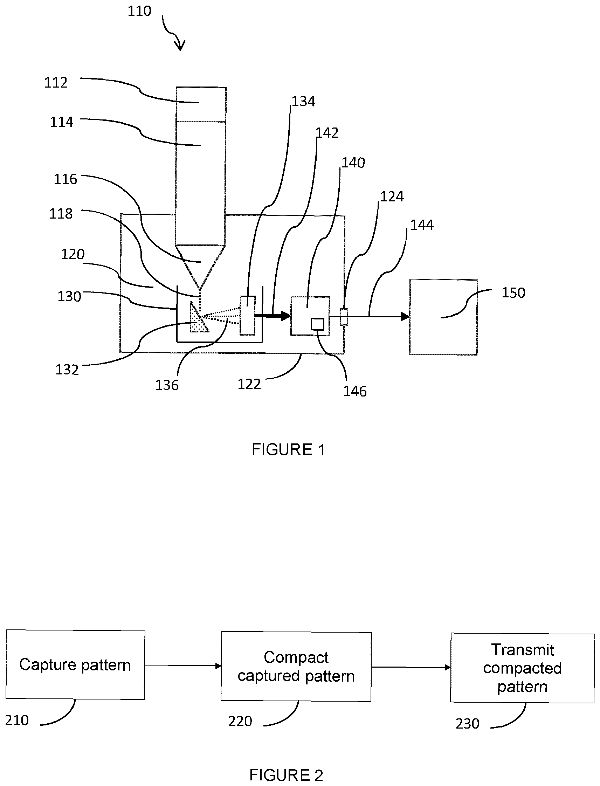

With reference to Figure 1, a disclosed electron microscope comprises an electron beam source 110 comprising an electron source 112, a column 114 and an objective 116 to generate an electron beam 118 inside a sample chamber 120. The sample chamber 120 is a vacuum chamber connected to a vacuum pump to maintain a vacuum inside the vacuum chamber during operation of the electron microscope and is defined inside a vessel wall 122 to contain the vacuum. The vessel wall 122 is provided with a feedthrough 124 to enable a data connection cable to pass through the vessel wall 122 without compromising the vacuum inside.

A sample holder 130 is configured to carry a specimen 132 in a fixed or adjustable position relative to an image detector 134 while intersecting the electron beam 118 so that, in use, a diffraction pattern 136 is generated at the image detector 134. The diffraction pattern may be a backscatter or transmission diffraction pattern. The image detector 134 may be integrated with or separate from the sample holder 130. The sample holder 130 and electron beam source 110 are configured so that the specimen and electron beam 118 can move relative to each other to scan the electron beam 118 across the specimen 132. For example, the electron beam source 110 may be configured to steer the electron beam 118 to scan it across the specimen 132 or the sample holder 130 may be moveable relative to the electron beam source 110 to achieve this relative motion.

An internal computing device 140 disposed inside the sample chamber 120 is connected to the image detector by means of a high data rate connection 142, and to an external computing device 150 by means of a low data rate connection 144 passing through the feedthrough 124. The internal computing device 140 may comprise one or more of a Central Processing Unit 146, various co-processors and memories connected by a data bus, for example as described in more detail below. The internal computing device may instead or additionally comprise a combination of Graphic Processing Units, Numeric Processing Units, Tensor Processing Units or Field Programmable Gate Array processing units. As will be described in more detail below, the internal computing device is configured to receive and compact the image data of the diffraction pattern 136 captured by the image detector 134 and to transmit the compacted pattern data via the data connections 142, 144 to the external computing device 150, for example for storage, display or further processing. As will be described in more detailed below, compaction may include image compression or computing of diffraction or crystallographic data.

The low data rate connection 144 is capable of sustaining data transmission at a maximum data transmission rate that is lower than that of the high data rate connection 142 and is configured to be compatible with the feedthrough 124. For example, the maximum sustainable data rate of the high data rate 142 connection may be of the order of 1000 MB/s and that of the low data rate connection 144 may be of the order of 10 MB/s, for example 3Mb/s. The low data rate connection 144 may be implemented by any data rate connections suitable for or provided by the feedthrough 124, for example a flex-PCB cable or general input/output cable, in some cases with pogo pin connections. The image detector may generate of the order of 1000 images a second with a resolution of 256x256 pixels, requiring data rates close to 100 MB/s, possibly 100-1000 MB/s, for the high data rate connection 142.

With reference to Figure 2, a method of operating the electron microscope is described. The electron beam 118 is scanned across the specimen 132 in a conventional manner. At step 210, a diffraction pattern 136 is captured at each scan location, using the detector 134, in the form of image data. The image data may for example be in the form of intensity or grayscale values at each of the pixels of the image detector. The image data may be in any suitable file formal, for example raw pixel intensities or in a high-fidelity file format such as RAW or BMP. The image data is transmitted to the internal computing device 140.

The internal computing device 140, at step 220, processes the captured pattern to compact it, to generate compacted data that has less memory / bandwidth resource requirements than the image data, that is represented by fewer bits, for example. In some examples, the compacted data can be compressed image data, for example in JPEG format.

In other examples, the compacted data is diffraction data in the sense that it characterises features of the diffraction pattern by a numerical representation in an appropriate space, for example characterising diffraction peaks or lines. Suitable spaces comprise momentum or Hough spaces. The compacted data may instead or additionally characterise crystallographic data, so that the numerical representation may characterise crystal lattice spacing, configuration and/or orientation of crystal(s) in the specimen 132 at the scan location. In the case of a backscattered diffraction pattern, the pattern may be an EBSD pattern and the compacted data may characterise Kikuchi lines. In the case of a transmitted diffraction pattern, the diffraction pattern may be an ND STEM pattern and the compacted data may characterise intensities of diffraction orders and/or peaks in the diffraction pattern.

It can be seen that the compacted data may be compressed image data or may be diffraction data or crystallographic data, that is the compacted data may be compacted in the sense that it comprises a numerical representation that describes or characterises the diffraction pattern or the corresponding crystal structure. For example, with the compacted data corresponding to Kikuchi lines in the case of EBSD, the compacted data may require less than 1% of the original bandwidth required for the image data. Of course, the diffraction data may further be compressed, for example using loss-less numeric compression techniques or by limiting its numeric precision.

At step 220, the compacted data is transmitted from the internal computing device 140 via the low data rate connection 144, via the feedthrough 124, to the external computing device 150. The external computing device may store the compacted data for later processing, may display the compacted data to a user, may further transmit the compacted data to another computing device, and so forth.

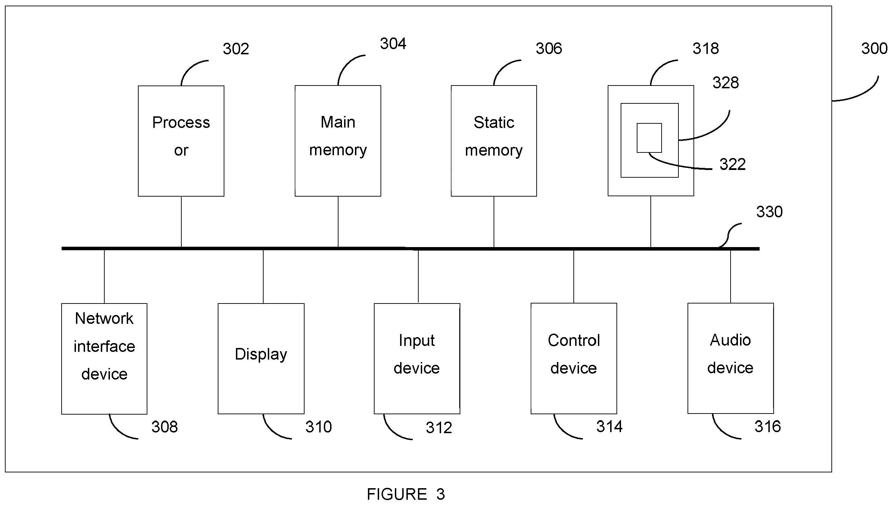

Figure 3 illustrates a block diagram of one implementation of a computing device 300 within which a set of instructions, for causing the computing device to perform any one or more of the methodologies discussed herein, may be executed. The computing device 140 and/or 150 described above may be implemented by computing device 300 and may have some or all components of the computing device 300. For example, the computing device 140 may not have a display or audio device and may only have those devices that are needed to implement its function. While only a single computing device is illustrated, the term "computing device" shall also be taken to include any collection of machines (e.g., computers) that individually or jointly execute a set (or multiple sets) of instructions to perform any one or more of the methodologies discussed herein.

The computing device 300 includes a processing device 302, a main memory 304 (e.g., read-only memory (ROM), flash memory, dynamic random access memory (DRAM) such as synchronous DRAM (SDRAM) or Rambus DRAM (RDRAM), etc.), a static memory 306 (e.g., flash memory, static random access memory (SRAM), etc.), and a secondary memory (e.g., a data storage device 318), which communicate with each other via a bus 330.

Processing device 302 represents one or more general-purpose processors such as a microprocessor, central processing unit, or the like. More particularly, the processing device 302 may be a complex instruction set computing (CISC) microprocessor, reduced instruction set computing (RISC) microprocessor, very long instruction word (VLIW) microprocessor, processor implementing other instruction sets, or processors implementing a combination of instruction sets. Processing device 302 may also be one or more special-purpose processing devices such as an application specific integrated circuit (ASIC), a field programmable gate array (FPGA), a digital signal processor (DSP), network processor, or the like. Processing device 302 is configured to execute the processing logic (instructions 322) for performing the operations and steps discussed herein.

The computing device 300 may further include a network interface device 308. The computing device 300 also may include a video display unit 310 (e.g., a liquid crystal display (LCD) or a cathode ray tube (CRT)), an alphanumeric input device 312 (e.g., a keyboard or touchscreen), a cursor control device 314 (e.g., a mouse or touchscreen), and an audio device 316 (e.g., a speaker).

The data storage device 318 may include one or more machine-readable storage media (or more specifically one or more non-transitory computer-readable storage media) 328 on which is stored one or more sets of instructions 322 embodying any one or more of the methodologies or functions described herein. The instructions 322 may also reside, completely or at least partially, within the main memory 304 and/or within the processing device 302 during execution thereof by the computer system 300, the main memory 304 and the processing device 302 also constituting computer-readable storage media.

The methods described above may be implemented by a computer program. The computer program may include computer code arranged to instruct a computer to perform the functions of one or more of the various methods described above. The computer program and/or the code for performing such methods may be provided to an apparatus, such as a computer, on one or more computer readable media or, more generally, a computer program product. The computer readable media may be transitory or non-transitory. The one or more computer readable media could be, for example, an electronic, magnetic, optical, electromagnetic, infrared, or semiconductor system, or a propagation medium for data transmission, for example for downloading the code over the Internet. Alternatively, the one or more computer readable media could take the form of one or more physical computer readable media such as semiconductor or solid state memory, magnetic tape, a removable computer diskette, a random access memory (RAM), a read-only memory (ROM), a rigid magnetic disc, and an optical disk, such as a CD-ROM, CD-R/W or DVD.

In an implementation, the modules, components and other features described herein can be implemented as discrete components or integrated in the functionality of hardware components such as ASICs, FPGAs, DSPs or similar devices.

A "hardware component" is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may be or include a special-purpose processor, such as a field programmable gate array (FPGA) or an ASIC. A hardware component may also include programmable logic or circuitry that is temporarily configured by software to perform certain operations.

Accordingly, the phrase "hardware component" should be understood to encompass a tangible entity that may be physically constructed, permanently configured (e.g., hardwired), or temporarily configured (e.g., programmed) to operate in a certain manner or to perform certain operations described herein.

In addition, the modules and components can be implemented as firmware or functional circuitry within hardware devices. Further, the modules and components can be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilizing terms such as " receiving", "determining", "comparing ", "enabling", "maintaining," "identifying, "compacting", "capturing" or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

It is to be understood that the above description is intended to be illustrative, and not restrictive. Many other implementations will be apparent to those of skill in the art upon reading and understanding the above description. Although the present disclosure has been described with reference to specific example implementations, it will be recognized that the disclosure is not limited to the implementations described, but can be practiced with modification and alteration within the spirit and scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

## Claims

1. An electron microscope comprising:
an electron beam source for producing an electron beam;
a vacuum chamber;
a sample holder disposed in the vacuum chamber to hold a specimen intersecting the electron beam;
an image detector disposed in the vacuum chamber to capture a diffraction pattern formed by electrons received from a sample held in the sample holder and produce image data comprising the captured diffraction pattern;
a computing device disposed in the vacuum chamber, connected to the image detector and configured to process the image data to produce compacted data from the image data, wherein the compacted data requires less storage or bandwidth than the image data;
a data connection connecting the computing device to a data transmission, storage or further computing device outside the vacuum chamber to make the compacted data available outside the vacuum chamber.

2. The electron microscope of claim 1, wherein the compacted data comprises a compressed image of the diffraction pattern.

3. The electron microscope of claim 1, wherein the compacted data characterises the captured diffraction pattern.

4. The electron microscope of claim 3, wherein the compacted data characterises the captured diffraction pattern in momentum space or in Hough space, or wherein the compacted data characterises a crystal lattice spacing, configuration and/or orientation at a location on the sample from which the electrons are received.

5. The electron microscope of any preceding claim wherein the computing device comprises a CPU.

6. The electron microscope of any preceding claim, wherein the compacted data comprises a numeric representation of features of the diffraction pattern.

7. The electron microscope of any preceding claim configured to capture diffraction patterns formed by backscattered electrons.

8. The electron microscope of claim 7, wherein the diffraction pattern is an EBSD pattern and the compacted data comprises data characterising Kikuchi lines.

9. The electron microscope of any one of claims 1 to 6, wherein the diffraction pattern is formed by transmitted electrons.

10. The electron microscope of claim 9, wherein the diffraction pattern is an ND STEM diffraction pattern and the compacted data comprises intensities of diffraction orders and/or diffraction peaks in the diffraction pattern.

11. The electron microscope of any preceding claim, wherein the electron microscope is configured to scan the electron beam across a plurality of locations on a sample held in the sample holder and the computing device is configured to process the image data and produce an instance of the compacted data for each of the plurality of locations.

12. The electron microscope of any preceding claim, wherein the detector and/or computing device are integrated with the sample holder.

13. A method of operating the electron microscope of any preceding claim, the method comprising:
capturing a diffraction pattern formed by electrons received from a specimen held in the sample holder and producing image data comprising the captured diffraction pattern;
processing the image data to produce compacted data from the image data, wherein the compacted data requires less storage or bandwidth than the image data; and
making the compacted data available outside the vacuum chamber.

14. The method of claim 13, wherein the diffraction pattern is an EBSD pattern and the compacted data comprises data characterising Kikuchi lines.

15. The method of claim 13, wherein the diffraction pattern is an ND STEM diffraction pattern and the diffraction data comprises diffraction orders and/or intensities of diffraction peaks in the diffraction pattern.
